# EUROPEAN PATENT APPLICATION

(11) **EP 2 230 891 A1**
(43) Date of publication of application: **22.09.2010**
(21) Application number: 09004004.9
(22) Date of filing: 20.03.2009
(51) Int. Cl.: H05K 3/44

(54) **Procedure for manufacture of printed circuit boards with high thermal conductibility base materials suitable for insertion on non-superficial components**

(71) Applicant: Eurocir, S.A., 08210 Barbera del Valles Barcelona (ES)
(72) Inventor: Llonqeras Arola, Juan, Barcelona (ES)
(74) Representative: Tari Lazaro, Aida

(57) **Abstract**

The procedure comprises as essential steps of the invention the die-stamping of a metal plate (1) in order to obtain drill-holes (2) numerically and positionally adequate for the insertion of non-superficial components; the arrangement of the metal base plate (1) on a suction template (3) provided with suction holes (4) arranged in correspondence with the drill-holes (2); the descent of the injection head (5) of a conventional printing machine on the metal base plate (1) and injection of an insulating resin (7) via injection holes (6), while the air is evacuated from the drill-holes (2) via the suction holes (4); and the die-stamping of the assembly thus obtained in order to obtain an insertion die (12) of smaller diameter than the corresponding initial drill-hole (2).

## Description

The present invention relates to the introduction of technological improvements in order to strengthen the functionality and efficacy of printed circuit boards manufactured with high thermal conductivity materials (IMS) based on the use of metallic materials, generally aluminium, as physical support for a metal lamina, normally copper, on one of its faces.

This type of materials and printed circuit boards have been developed in response to the evolution of the requirements of the electronics industry in relation to new applications where the working temperature presents a problem on account of the use of high calorific power components.

The printed circuit board obtained by the procedure of the invention can be advantageously used in a wide spectrum of applications where thermal dissipation is a decisive factor, for example,
- The lighting industry (LED circuits)
- Automobiles (ignition systems, lighting, etc.)
- Solid state relays
- Power boards (converters, inverters, etc.)

### Background of the invention

Owing to the increase in the use of high calorific power components, it has become necessary to develop printed circuits based on new technologies which, by means of using new processes and new materials, permit the necessary improvements to be contributed in terms of dissipation of the heat generated by said components. So, new materials have been developed with high thermal conductivity giving rise to new technologies and processes.

As physical support for the printed circuits, the new materials introduce a metal base, primarily aluminium or copper, on which a metal lamina is provided, generally copper, where the conducting tracks defined by the design of the circuit are created, giving rise to connections between the different electronic components duly soldered to them. In order to provide the necessary electrical insulation between the conducting tracks and the metal base, a dielectric material is introduced between them, which guarantees the required electrical insulation with the minimum thermal resistance.

In this way, electrical contact between metals is avoided, at the same time offering the necessary heat transfer that is going to permit the metal base to absorb the temperature accumulated in the circuit and facilitate its consequent dissipation.

The structure that has just been described guarantees a high thermal dissipation, but it introduces a major limitation in terms of the type of electronic components applicable in this kind of printed circuit, in which it is necessary to use surface mount devices (SMD) since the assembly of any kind of component that needs to be inserted entails the loss of the insulation, due to electrical connection between the metals of the dissipating base and the conducting tracks via the actual component (insertion pin), or due to the actual soldering process.

Consequently, it is an objective of the present invention to provide a printed circuit board which, maintaining a high capacity for thermal dissipation, will permit the mounting of electronic components for insertion, developing the necessary procedure for its manufacture.

### Description of the invention

In order to achieve the proposed objective, a printed circuit board has been conceived in which the drill-holes of the metal base provided for housing the pins of the insertion components are duly insulated. The procedure for manufacturing the printed circuit board, generating and maintaining the insulation of the drill-holes therein, is the object of the present invention.

To do this, one starts from the metal base used as dissipater of the printed circuit, on which holes are drilled in the areas where, later on, the electronic components have to be inserted into the finished printed circuit board.

Next, the drill-holes that have been machined are proceeded to be filled by means of application of a resin of an insulating nature, in such a way that the hole is completely immersed and filled with that resin. This operation is the most delicate one, since it is essential to make sure that the resin does not overflow through the lower part of the drill-hole and adhere to the surface of the metal base opposite to the conducting tracks.

In order to achieve this, the filling resin must, together with its insulating nature, also offer certain characteristics in terms of its physical properties that in turn permit it to have the fluidity to penetrate inside the drill-hole, together with a thixotropy that will guarantee the complete coating of the interior of the drill-hole. Nevertheless, this is not sufficient for achieving the proposed objective, therefore specific measures have to be taken with regard to the means used for the application of the filling resin. In our case, the system of suction has been used for the screen-printing of the conducting tracks, suitably modified.

As a rule, the printing machines used for the manufacture of printed circuits include a suction system as part of the machine. This system is provided on the printing plate; in other words, on the surface where the material is placed on which the printing is going to be carried out. The aim is to guarantee a connect positioning, flatness and securing of the material in order to be able to perform the screen-printing with the necessary precision.

The suction system is achieved by means of a pump and an array of suction holes distributed at regular intervals on the printing plate intended to receive the material to print.

In the case that we are concerned with, that of seeking to completely cover a drill-hole with an insulating resin, the same suction system can be adapted for guaranteeing that the resin "falls" inside the hole. The problem to solve is that, if the drilled metal base is deposited on a flat surface, the drill-hole, which is open at the other end, becomes blind, and the pressure exerted by the air occluded in it is greater than the injection pressure of the filling resin, which is therefore not able to penetrate into the drill-hole uniformly. The proposed solution consists of sucking out the occluded air via a small suction hole provided in the surface on which the metal base rests.

Nevertheless, the habitual distribution of the suction points on the plate of the printing machine is regular, since their aim consists of keeping fixed a plate of material without drill-holes. As a consequence, it is necessary to provide a suction template, arranged above and separate from the plate of the machine, and provided with suction holes located in correspondence with the drill-holes of the metal base which we need to cover with the filling resin. In this way, and with a correct relative positioning between the metal base and the suction template, it is guaranteed that all the drill-holes to fill with resin have the necessary suction for avoiding the pressure that will otherwise prevent the resin from "falling".

The suction hole will always have a diameter considerably less than that of the drill-hole to fill, in order to prevent the resin from becoming introduced between the metal base and the suction template. In the injection process of the filling resin, the intensity of the suction together with the injection pressure of the resin are critical factors in obtaining the desired quality. The combination of both parameters with the diameter of the suction hole and the physical characteristics of the resin depend on the design of the circuit to manufacture and have to be adjusted by the method of trial and error.

Once the drill-hole made on the metal base has been filled with resin, the dielectric is then proceeded to be applied which permits the correct adhesion of the metal lamina where the later design of the conducting tracks is going to be made, in turn guaranteeing the electrical insulation between the two metal parts.

Following the process of incorporation of the metal lamina, the assembly is obtained constituting the board in the strict sense, on which the conducting tracks are created in such a way that, duly traced, they will later on permit the connections to be established between the different electronic components to be assembled.

Next, the soldering mask, identification inks, or new conducting inks, can be applied, in order to complete the design of the required printed circuit.

Finally, the board is die-stamped, in order to permit mounting of the inserted components, bearing in mind that the die has to be of diameter less than the initial drill-hole that has been made previously and which has been filled with insulating resin, as has been described, and it has to be perfectly centred and positioned on it. In this way, thanks to the insulating resin that covers the walls of the new drill-hole, the correct insulation between the metal parts of the assembly is guaranteed.

### Brief description of the drawings

In order to complement the above description, and with the aim of aiding a better understanding of the characteristics of the invention, a detailed description is going to be made of a preferred embodiment, on the basis of a set of plans that accompany this specification and in which, on an orientative and non-limiting basis, the following have been represented:
Figure 1 shows a printed circuit board produced according to the prior art.
Figure 2 shows, in cross-section, the metal base constituting the dissipating element.
Figure 3 shows, in cross-section, the metal base after the drilling phase.
Figure 4 shows, in cross-section, the arrangement of the different elements involved in the phase of filling the drill-holes with insulating resin.
Figure 5 shows, in cross-section, the metal base plate with the drill-holes filled with insulating resin.
Figure 6 shows, in cross-section, the arrangement of the insulating dielectric.
Figure 7 shows, in cross-section, the assembly following the application of the metal lamina.
Figure 8 shows, in cross-section, the assembly following the application of the inks resistant to chemical attack.
Figure 9 shows, in cross-section, the assembly following the chemical attack.
Figure 10 shows, in cross-section, the assembly following the printing of the soldering mask.
Figure 11 shows, in cross-section, the final die for insertion of components.

In the above figures, the numerical references refer to the following parts and elements:
1. Metal base plate
2. Drill-holes
3. Suction template
4. Suction holes
5. Injection head
6. Injection holes
7. Insulating resin
8. Dielectric
9. Metal lamina
10. Unprotected zones
11. Auxiliary inks
12. Insertion die
13. Etch-resistant ink

### Detailed description of the preferred embodiment

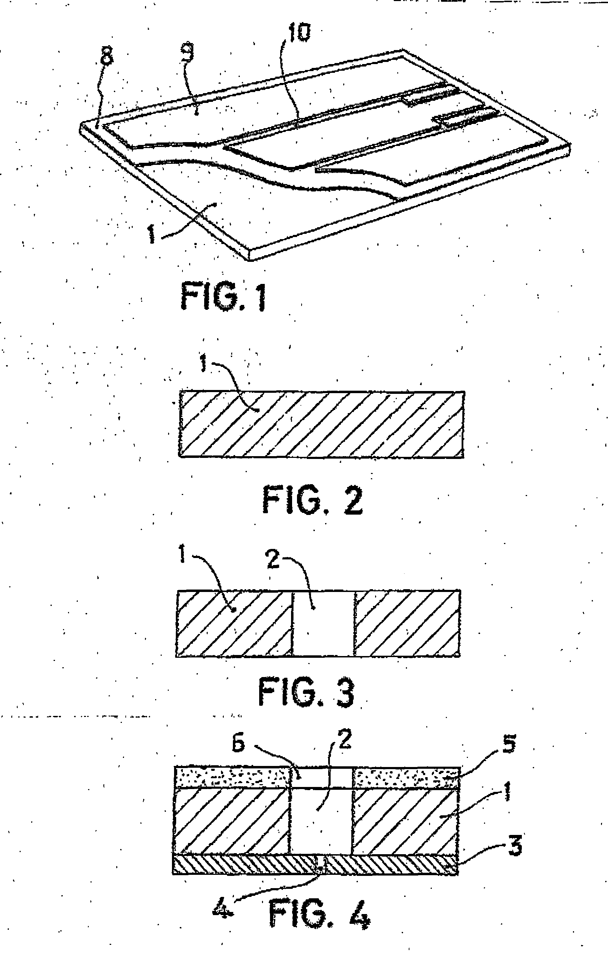

As can be seen in the figures, the procedure starts from a metal base (1) on which a die-stamping operation is going to be carried out, obtaining drill-holes (2) numerically and positionally adequate for the later insertion of the electronic components of the circuit. See figures 2 and 3.

Next the metal base plate (1) is deposited on a suction template (3) provided with the appropriate suction holes (4) arranged in correspondence with the drill-holes (2). The injection head (5) of the printing machine, provided with injection holes (6) of the same diameter as the drill-holes (2), is located on the metal base (1). See figure 4.

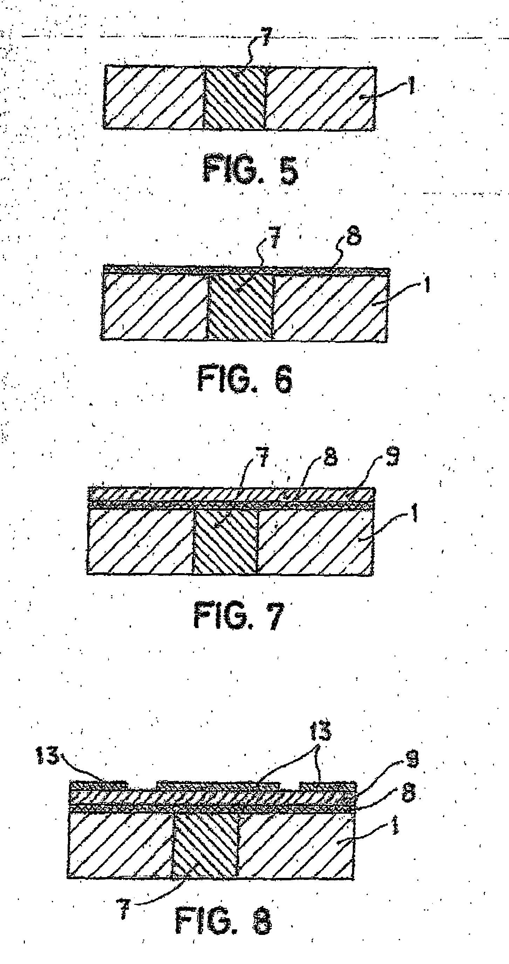

The insulating resin (7) is then applied to the assembly, subjected a certain pressure, while the air is evacuated from the drill-holes (2) via the suction holes (4) until they are filled, as can be seen in figure 5. An acrylate polymer, obtained by exposure to ultraviolet light, is advantageously used as insulating resin (7), more specifically Durashield V42 Mono Filter from the firm ELECTRA.

In this way, a compact block is again obtained on which the dielectric layer (8) is applied. See figure 6.

A metal lamina (9) is deposited on the assembly formed, said lamina constituting the conducting element of the circuit. See figure 7.

By means of the application of an etch-resistant ink (13) and its printing by photographic and/or screen printing techniques, which will be very well known to an expert in the subject, certain zones of the metal lamina (9) are left unprotected. See figure 8.

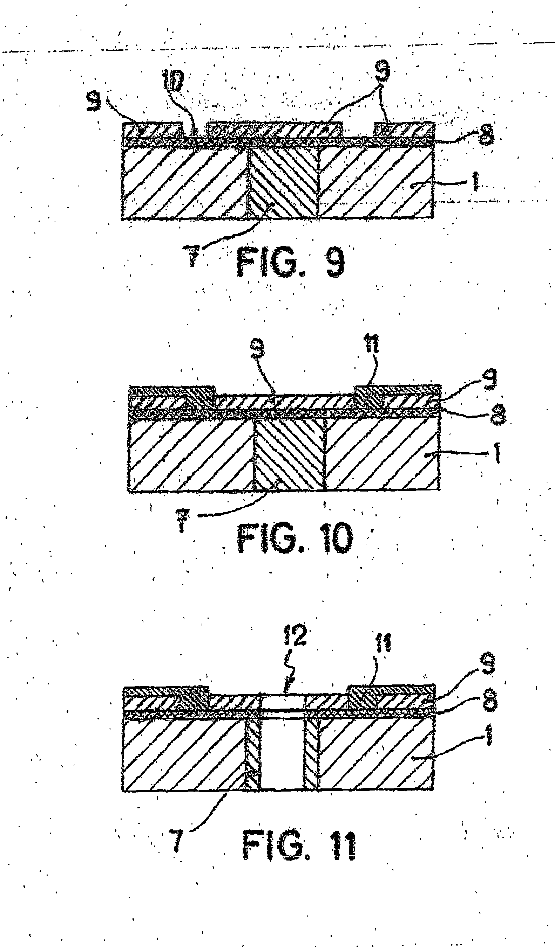

Following the chemical attack, which will be very well known to an expert in the subject, and once the etch-resistant ink (13) has been eliminated, there will remain defined an electric circuit consisting of conducting tracks formed by the metal lamina (9) which has been attacked in unprotected zones (10) by the etch-resistant ink (13). See figure 9.

Next, auxiliary inks (11) are proceeded to be applied, such as might be soldering masks, identification inks, conducting inks, etc., which make up the printed circuit board. See figure 10.

Finally, as shown in figure 11, the assembly is proceeded to be die-stamped, obtaining an insertion die (12) of smaller diameter than the corresponding drill-hole (2), due to which it remains coated with the insulating resin (7), which guarantees that there cannot exist any electrical contact between the metal base (1) and the pins of the insertion components. See figure 11.

It is not considered necessary to make this description any more extensive so that any expert in the subject can understand the scope of the invention and the advantages deriving from it. For the same reason, certain processes that are widely known in the manufacture of printed circuits are not gone into in detail.

## Claims

1. Procedure for manufacture of printed circuit boards with high thermal conductivity base materials suitable for insertion of noun-superficial components, **characterized by** comprising the following steps:
- Die-stamping of a metal plate (1) in order to obtain drill-holes (2) numerically and positionally adequate for the insertion of non-superficial components.
- Arrangement of the metal base plate (1) on a suction template (3) provided with suction holes (4) arranged in correspondence with the drill-holes (2)
- Descent of the injection head (5) of a conventional printing machine on the metal base plate (1) and injection of an insulating resin (7) via injection holes (6), while the air is evacuated from the drill-holes (2) via the suction holes (4).
- Application of a dielectric layer (8) on the assembly thus obtained.
- Depositing of a metal lamina (9).
- Application of an etch-resistant ink (13) and its printing with the design of the circuit using conventional techniques.
- Chemical attack of the zones (10) not protected by the etch-resistant ink (13) in order to create conducting tracks on the metal lamina (9).
- Application of auxiliary inks (11), for example, soldering masks, in the conventional way.
- Die-stamping of the assembly thus obtained in order to obtain an insertion die (12) of smaller diameter than the corresponding drill-hole (2).

2. Procedure for manufacture of printed circuit boards in accordance with claim 1, **characterized in that** the insulating resin (7) comprises an acrylate polymer obtained by exposure to ultraviolet light.
